Europäisches Patentamt

European Patent Office

Office européen des brevets

(19)

(11) EP 0 593 124 B1

(12) EUROPEAN PATENT SPECIFICATION

(45) Date of publication and mention
of the grant of the patent:
**29.12.1999 Bulletin 1999/52**

(51) Int Cl.⁶: **G03H 1/00**, G03F 7/00

(21) Application number: **93202866.5**

(22) Date of filing: **08.10.1993**

(54) **Apparatus and method for the manufacture of high uniformity total internal reflection holograms**

Vorrichtung und Verfahren zum Herstellen von inneren Totalreflexionshologrammen hoher Uniformität

Dispositif et méthode pour la production d'hologrammes à réflexion interne totale de haute uniformité

(84) Designated Contracting States:
CH DE FR LI NL

(30) Priority: **14.10.1992 GB 9221561**

(43) Date of publication of application:
**20.04.1994 Bulletin 1994/16**

(73) Proprietor: **Holtronic Technologies Plc**
**London EC4A 1NH (GB)**

(72) Inventor: **Clube, Francis Stace Murray**
**CH-2000 Neuchâtel (CH)**

(74) Representative: **Hasler, Erich, Dr. et al**
**Patentanwaltsbüro**
**Dr. Conrad A. Riederer**
**Bahnhofstrasse 10**
**7310 Bad Ragaz (CH)**

(56) References cited:
EP-A- 0 421 645          WO-A-90/13062
US-A- 3 551 018          US-A- 3 650 605

- **PROCEEDINGS OF THE SPIE : OPTICAL/LASER MICROLITHOGRAPHY V, vol.1674, no.2, March 1992, BELLINGHAM, US pages 783 - 792 FRANCIS CLUBE ET AL. 'HOLOGRAPHIC MASK ALIGNER'**
- **SOLID STATE TECHNOLOGY, vol.34, no.9, September 1991, WASHINGTON US pages 89 - 93 BASIL A. OMAR ET AL. 'ADVANCES IN HOLOGRAPHIC LITHOGRAPHY'**

## Description

FIELD OF THE INVENTION

The present invention relates generally to the field of total internal reflection holography. In particular it relates to total internal reflection holography as employed for microlithography.

BACKGROUND ART

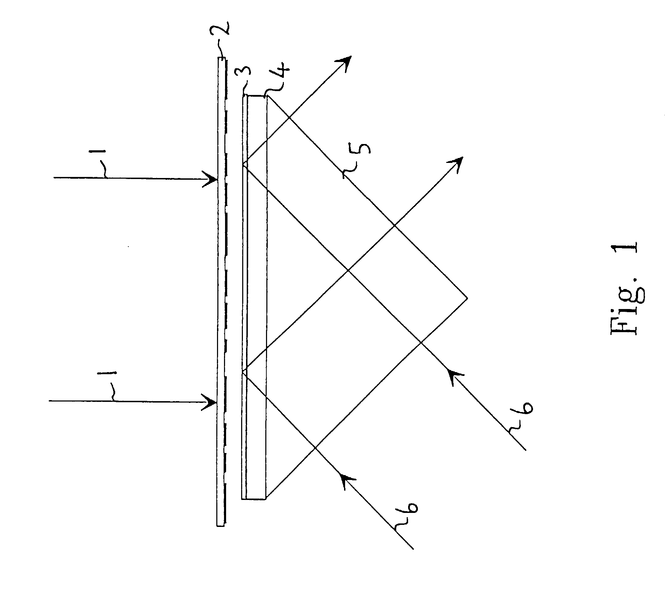

In the prior art total internal reflection (TIR) holograms [1-6] are constructed from expanded laser beams as shown schematically in Fig. 1. One of these, the object beam 1, is directed through a mask transparency 2 to a holographic recording layer 3 on a substrate 4 in optical contact with a large prism 5. The other, the reference beam 6, is directed through another face of the prism 5 so that it is totally reflected from the surface of the holographic layer 3. The optical interference of the two beams is recorded by the layer's photosensitive material. Once fixed, the hologram can be reconstructed by irradiating it with a laser beam directed in the opposite direction to the original reference beam 6.

TIR holograms have the capability of recording and reconstructing images over large geometrical areas. With modern photopolymeric recording materials, TIR holograms have shown significant potential for high resolution photolithography. [3-6]

One of the problems encountered when applying TIR holography to photolithography, such as for the microelectronics industry, is that the brightness of the reconstructed images needs to be very uniform (preferably better than ±2%) over their areas. For this to be achieved with the prior art it is therefore desirable that at hologram recording the expanded laser beams have good uniformity across their wavefronts. Unfortunately this is difficult to achieve because of the natural variation in irradiance of a laser beam: most beams have a Gaussian intensity profile, making their edges less bright than their centre.

A more uniform lightfield at the recording layer could, in principle, be achieved by expanding the beam well beyond what is needed and using the centre only. However, beam uniformity achieved this way is only at the expense of the light available. It has been estimated that to achieve ±2% uniformity, only about 2% of the laser energy could be used and this would increase exposure times beyond practicality.

Uniformity of printing exposure could also be achieved by recording a hologram with a well-behaved efficiency non-uniformity (eg.Gaussian) across its surface and then, during printing, to compensate for the non-uniformity by scanning the reconstruction beam over the hologram area and varying either the beam's intensity or scan-speed as it scans. However, because of the compromises being made in both mean hologram efficiency and mean laser power, this would necessarily lead to longer print times and consequently a lower throughput, which are undesirable for many industrial applications. Also, the assumption of a Gaussian intensity profile can often be an over-simplification.

In addition, both the above methods for improving uniformity require low-aberration collimating lenses (or mirrors) operating in the UV (typically 364 nm) for generating the object and reference beams. For large diameter (eg. 8", 12", 20") holograms intended for, for instance, manufacturing large-area flat panel displays, this becomes most unattractive.

Another problem encountered in the manufacture of large area TIR holograms for microlithographic applications relates to the depth of focus of the reconstructed images. In order that a TIR hologram correctly prints an image onto, for instance, a silicon wafer, it is necessary that the wafer's surface be accurately positioned with respect to the projected image. If the wafer surface is either a small distance in front of or behind the image, the printed image will be out-of-focus. Typically, if the features in the image are of dimension ~ 0.5µm, the wafer surface needs to be positioned to ~±0.2µm accuracy. In order to facilitate this, it is desirable that all features in the reconstructed image lie at the same distance from the hologram's surface. Using the prior art this demands that the separation of the object mask and holographic layer during recording be the same (to ~ ±0.1µm) across their area. However, because of the difficulty in obtaining sufficiently flat object masks and sufficiently flat recording layers, and the difficulty in supporting them in such a way that they remain flat during hologram recording, the degree of parallelism required becomes impratical.

In seeking a solution to the above problems it is of prime importance to take into account the extreme sensitivity of hologram formation to mechanical (and other) instabilities. A hologram is a recording of an optical interference pattern and so will only be formed successfully if at each point on the recording surface the relative phases of the interfering object and reference beams are substantially constant during the exposure process. To quantify this, the relative phases should be constant to preferably better than 2 /10, meaning that the relative lengths of the object and reference beam optical paths to any point on the holographic layer should not change by more than ~30nm during the recording operation; if this condition is violated the interference pattern will be "washed out" and the hologram will be lost.

SUMMARY OF THE INVENTION

It is therefore an object of the present invention to provide a method whereby total internal reflection holograms can be recorded with high uniformity of exposure over large areas. The method and the apparatus claimed are defined in claims 1 and 6.

According to a first aspect of the present invention, there is provided a method for recording a total internal reflection hologram, which method includes:

a) dividing an input laser beam into an object beam and a reference beam;

b) directing the two beams to a holographic recording layer so that the object beam is incident on one surface of the holographic recording layer following transmission through an object mask, so that the reference beam is incident on the other surface of the holographic recording layer at an angle such that following passage through the holographic recording layer the beam is totally internally reflected back into the holographic recording layer and so that the object and reference beams are superposed at the holographic recording layer such that they are aligned and remain aligned as the beams traverse the holographic recording layer; and

c) displacing said input laser beam so that the object and reference beams traverse the holographic recording layer.

The method of the invention is particulary useful for obtaining a uniform exposure across the recording layer.
In this case the input beam would be displaced by a scanner system such that the beams traverse the layer in preferably a raster pattern.
The method may alternatively be used for deliberately introducing a particular non-uniformity of exposure across the recording layer, in which case either the intensity of the input laser beam or the motion of the scanner would be varied appropriately through the course of the scan.

The method may be employed to selectively expose a part or parts of the mask and holographic layer, with the possibility of changing the mask between parts of the exposure.

The method permits measurement (using, for instance, the technique as described in our Patent Application EP-A-0421645) and adjustment of the local separation of the object transparency and recording layer where exposure is taking place in order that a constant separation be obtained, for the purpose of enabling an accurately focussed image to be printed during hologram reconstruction.

A further advantage of scanning the construction beams is that it can significantly suppress the problem of laser speckle, especially that generated by large-area collimating optics and by beam apertures, thereby enhancing the quality of the reconstructed images.

By the above method, in which the mechanical scanning is performed prior to beam division, instabilities introduced into the laser wavefronts by irregularities in the motion of the scanner system are common to both object and reference beams, thus allowing their relative phases at the recording layer to remain substantially constant.

In TIR holography as described in the prior art, the object beam arrives at the holographic layer at or near normal incidence whereas the reference beam arrives at or near 45° incidence. Thus, if only mirrors were used to direct the object and reference beams to the recording layer, the reference beam would illuminate an area of the recording layer 2 times greater than the area occupied by the object beam and furthermore would scan across the layer at a speed 2 times faster than the object beam. The result would be a variation in holographic exposure over the layer. Beam superposition, so that the beams remain overlapped as they are scanned, as required in step (b) of the above method, can best be obtained by either

i) employing optical elements in the reference beam path to compress the beam in the plane of incidence of the reference beam at the holographic layer; or

ii) employing optical elements in the object beam path to expand the beam in the plane of incidence of the reference beam at the holographic layer.

The beam alignment in step (b) also provides stability of the relative phases of the interfering beams. The relative phases of the beams are sensitive to angular perturbations of the scanning beams introduced by, for instance, wobble (yaw, pitch and roll) of the scanner system. This sensitivity to scanner wobble is significantly reduced by providing accurate alignment between the superposed beams.

To the above method may be added the further step of arranging the paths of the object and reference beams to be such that the misalignment of the beams at the recording layer produced by an angular displacement of the object and reference beams, arising from a displacement of the input beam, is minimised, taking into account all parts of the holographic layer. This procedure serves to further suppress the sensitivity of the optical interference pattern recorded in the hologram to irregularities in the motion of the scanner system.

According to a second aspect of the present invention, there is provided an apparatus for recording a total internal reflection hologram, which apparatus includes:

a) a means for dividing an input laser beam into an object beam and a reference beam;

b) a means for directing the object and reference beams to a holographic recording layer so that the object beam is incident on a surface of the holographic recording layer following transmission through an object mask, so that the reference beam is incident on the other surface of the holographic recording layer at an angle such that following passage through the holographic recording layer it is totally internally reflected back into the holographic recording layer, and so that the object and reference beams are superposed at the holographic recording layer such that they are aligned and remain aligned as the beams traverse the holographic recording layer; and

c) a means for displacing the input laser beam so that the object and reference beams traverse the holographic recording layer.

For the (usual) case where the object beam arrives at the holographic layer at an angle of incidence smaller than that of the reference beam, feature (b) of the second aspect of the invention would preferably include either

i) a prism, cylindrical lens system or diffraction grating in the reference beam path to compress the beam in one dimension by refraction or diffraction; or

ii) a prism, cylindrical lens system or diffraction grating in the object beam path to expand the beam in one dimension by refraction or diffraction.

Feature (b) would preferably allow beam superposition to be carried out with precision (the accuracy depending primarily on the magnitude of wobble present in the scanner system) in order to suppress the sensitivity of the optical interference pattern to irregularities in the motion of the scanner system.

Feature (b) would preferably be employed for the additional purpose of arranging the paths of the object and reference beams to be such that the misalignment of the beams at the recording layer arising from an angular displacement of the object and reference beams, caused by a displacement of the input beam, is minimised, taking into account all parts of the recording layer. In this way the sensitivity of the relative phases of the interfering object and reference beams to angular perturbations of the beams caused by, for instance, mechanical wobble of the scanner system can be minimised.

If scanning is being performed in order that all parts of the reconstructed image lie at the same distance from the holographic layer, the above apparatus would further include a means for measuring the separation of all parts of the object transparency and the holographic layer over their area and a means for adjusting the separation such the separation where exposure is taking place remains constant as the beams are scanned.

DESCRIPTION OF THE DRAWINGS

The present invention will now be described in greater detail by way of example with reference to the accompanying drawings, wherein : -

Fig.**1**, already described, shows the main principles of TIR holography.

Fig.**2** is a schematic representation of one preferred embodiment for recording a total internal reflection hologram with high uniformity of exposure.

Fig.**3** labels the lengths of the various sections of the object and reference beam paths.

DESCRIPTION OF THE PREFERRED EMBODIMENTS

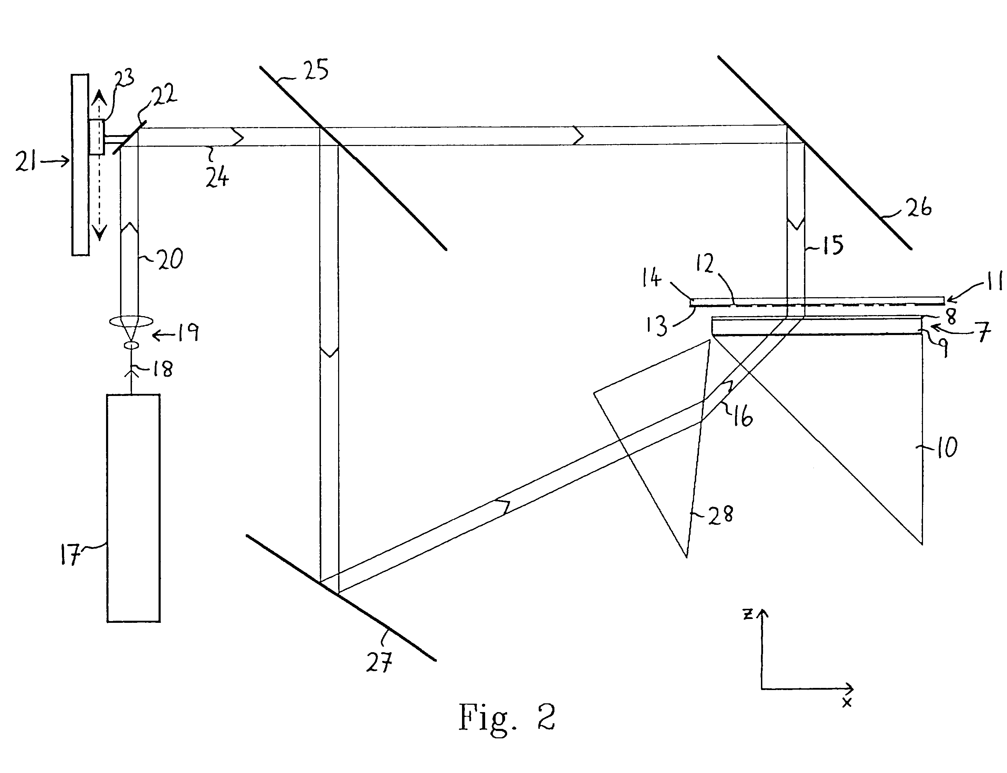

In the arrangement of Fig. **2**, a holographic plate **7**, comprising a thin (typically 20μm) layer **8** of a holographic recording material spun onto a glass substrate **9** of dimensions ~10cm x 10cm, is placed in optical contact with one of the shorter sides of a 45°, 45°, 90° glass prism **10**. A suitable holographic recording material would be one of the holographic photopolymers manufactured by DuPont de Nemours & Co, such as that identified by HRS-352, which is sensitive in the UV and records an optical interference pattern as a modulation of refractive index. Optical contacting of the holographic plate **7** to the prism **10** may be achieved using xylene, a transparent fluid that has low volatility and a refractive index close to that of glass.

Above the recording layer **8** and in proximity to it is positioned an object mask **11** comprising features **12** etched into a layer of chrome **13** on the surface of a glass plate **14**. The mask is located on piezo-electric transducers (not shown in the figure) which permit the mask to be located at a particular distance and parallel to the layer.

Two mutually coherent laser beams, an object beam **15** and a reference beam **16**, illuminate this system. The two are derived from an argon ion laser **17** operating at a wavelength of 364nm and incorporating an etalon to give the beam a high temporal coherence. The output **18** of the laser passes through a beam expander **19** transforming it into a ~2cm diameter (defined by the $1/e^2$ intensity points) collimated beam **20** with a Gaussian profile. The beam **20** enters a mechanical scanner system **21** comprising mirrors **22** mounted on two computer-controlled stages **23** that travel parallel to the y and z axes respectively (in the figure only a one-dimensional stage movement is however illustrated). The motion of the stages is such that the input beam **24** leaving the system, oriented parallel to the x-axis, is raster scanned across a large beamsplitter **25**. A step size of 5mm (ie. ~1/4 of the beam diameter) between successive passes of the scanning motion ensures that the integrated light intensity at the holographic layer has good uniformity. The speed, v, of each scan pass is determined from the energy density, E, necessary to expose the hologram, according to

$$v = \frac{P}{E \times s}$$

where P is the power in the input beam **24** and s is the size of the step between successive passes of the scan.

So, if the exposure energy density required is 20mJ/cm², the power in the input beam is 100mW and the step size is 5mm, the scan speed necessary is 10cm/s.

It should be noted that a scanning motion of the beam at the holographic layer could also be generated by a rotational motion of a mechanical scanner.

That part of the beam transmitted by the beamsplitter **25**, forming the object beam **15**, is reflected from a mirror **26** and arrives at the object mask **11** at normal incidence, thence illuminating the recording layer **8**. The part of the beam reflected by the beamsplitter **25**, forming the reference beam **16**, is reflected by a mirror **27** and enters at normal incidence a face of an auxiliary glass prism **28**. The beam refracted by the auxiliary prism **28** passes through the hypotenuse face of the prism **10** supporting the holographic plate **7**, arriving at the holographic layer **8** at an angle of 45°, whereupon it is totally internally reflected from the upper surface of the layer **8**.

From the figure it can be seen that although the object and reference beams **15 and 16** are incident on the holographic layer **8** at very different angles, they illuminate equal areas. Furthermore, as the input beam **24** is scanned across the beamsplitter **25**, so the object and reference beams **15 and 16** traverse the layer **8** at the same speed. This is attributable to the auxiliary prism **28** which has the function of compressing the reference beam **16** in the plane of incidence of the reference beam at the layer **8** in order to compensate for the beam's projected cross-section at the layer **8**. In general terms, if the angles of incidence of the object and reference beams **15 and 16** at the recording layer **8** are $\theta_o$ and $\theta_r$ respectively then the required compression factor, c, that is, the ratio of the widths $w_2$ and $w_1$ of the beams leaving and entering the auxiliary prism **28**, is given by

$$c = \frac{w_2}{w_1} = \frac{\cos \theta_r}{\cos \theta_o}$$

The angle, $\phi$, required between the two faces of the auxiliary prism **28** oriented as in figure 2 for producing a compression factor c is calculated from

$$\sin^2 \phi = \frac{1 - c^2}{n^2 - c^2}$$

where n is the refractive index of the auxiliary prism material.

So, for the particular geometry under consideration, in which $\theta_o = 0°$ and $\theta_r = 45°$, the compression factor required is 0.707. Hence, taking the refractive index of the prism material as 1.5, the angle, $\phi$, needed between the two faces of the auxiliary prism **28** is ~32°.

Equalisation of the object and reference beam diameters at the holographic layer **8** could alternatively be accomplished by employing the auxiliary prism **28** in the object beam path in order to expand the object beam **15**.

The paths of the object and reference beams **15 and 16** are also arranged in order to suppress the sensitivity of the optical interference pattern recorded in the holographic layer to wobble (pitch, roll or yaw) of the scanner system **21**.

It requires firstly that the object and reference beams **15 and 16** are accurately aligned at the holographic layer **8**. The precision of beam alignment depends on the degree of wobble present in the scanner system **21**, but typically if the scanner wobbles by ~0.1mR, the beams **15 and 16** should be aligned to better than ½mm. It may be a accomplished by introducing a knife edge into the input beam **24** before the beamsplitter **25** and then adjusting the positions and orientations of the optical elements in the object and reference beam paths until the projected shadows of the knife edge in the object and reference beam are coincident at the plane of the recording layer. The shadows in the UV beams may be observed with the aid of a fluorescent screen.

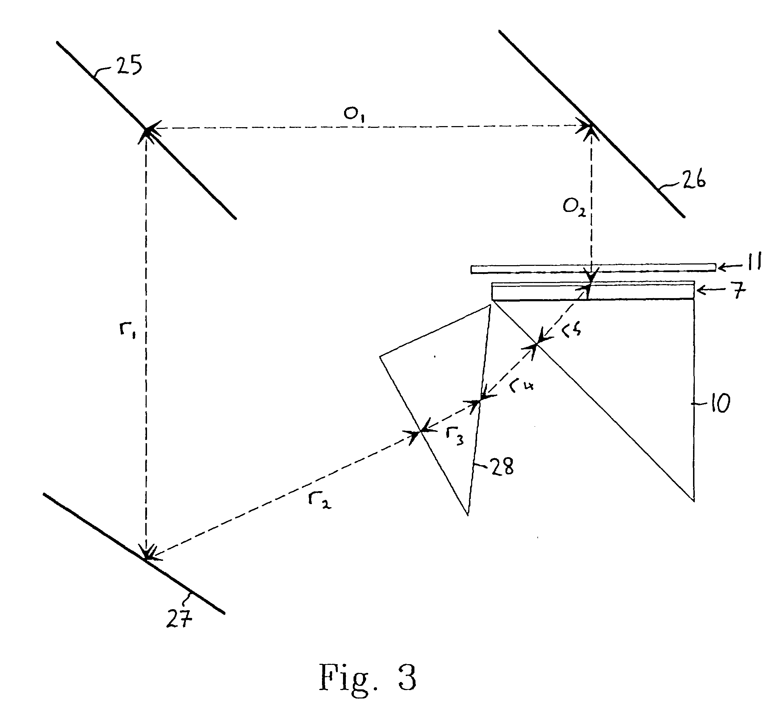

The second consideration is the minimisation of beam misalignment at the holographic layer produced by an angular displacement of the input beam **24** due to wobble of the scanner system. This minimisation should take into account angular displacements of the input beam in both planes (xy and xz) and should take into account all parts of the holographic layer **8**. Referring to Fig. 3, which labels the lengths of the various sections of the object and reference beam paths, the sensitivity of the optical interference pattern to scanner wobble is kept low if it is arranged that

$$o_1 + o_2 = r_1 + r_2 + \frac{r_3}{n} + \frac{3r_4}{2} + \frac{3r_5}{2n}$$

where n is the refractive index of glass.

With the beam paths satisfying the above condition, hologram recording is reasonably tolerant to wobble in the scanner system. It should be mentioned that incorporating the auxiliary prism **28** in the object beam path near the mask **11** permits enhanced insensitivity of the interference pattern to scanner wobble (because the condition on the relative optical path lengths of the object and reference beams for minimising the sensitivity to wobble of the input beam in the xy plane and the corresponding condition for the xz plane are more similar), but may be at the expense of accessibility to the mask **11** and holographic plate **7**.

Once the laser beams **15 and 16** have completed their scan the holographic plate **7** is removed from the prism **10** and the holographic layer **8** is fixed. For those holographic materials where the efficiency of the hologram is dependent on the time delay between holographic exposure and fixing, the fixing is best carried out by gradually introducing the plate to the fixing process in order that the time delay between exposure and fixing for each part of the holographic layer is the same. In the case of fixing by incoherent UV illumination, this may be achieved by combining a UV illumination source, condenser and collimation optics with the holographic exposure apparatus and modifying the scanning system such that an incoherent UV beam scans the holographic layer behind or after the hologram-forming beams.

Hologram reconstruction may then proceed.

References:

1. K. Stetson, "Holography with Totally Internally Reflected Light", Applied Physics Letters, vol.11, p. 225 (1967).

2. I.N. Ross, G.M. Davis, D. Klemitz, "High Resolution Holographic Image Projection at Visible and Ultraviolet Wavelengths", Applied Optics, vol.27, p. 967 (1988).

3. R.Dändliker, J.Brook, "Holographic Photolithography for Submicron VLSI Structures", IEEE Conf. Proc.Holographic Systems, Components and Applications, Bath, U.K., p.311 (1989).

4. S.Gray, M.Hamidi, "Holographic Microlithography for Flat Panel Displays", SID 91 Digest pp.854-857 (1991).

5. B.A.Omar, F.Clube, M.Hamidi, D.Struchen, S. Gray, "Advances in Holographic Lithography", Solid State Technology, pp.89-93, Sept.1991.

6. F. Clube, S. Gray, M. Hamidi, B. Omar, D. Struchen, J-C Tisserand, "Holographic Mask-Aligner", SPIE Optical / Laser Microlithography V, vol. 1674 pp.783-792 (1992).

**Claims**

1. A method for recording a total internal reflection hologram, which method includes:

   a) dividing an input laser beam into an object beam (15) and a reference beam (16) ;
   b) directing the object and reference beams (15,16) to a holographic recording layer (8) so that the object (15) beam is incident on a surface of the holographic recording layer (8) following transmission through an object mask (11), so that the reference beam (16) is incident on the other surface of the holographic recording layer (8) at an angle such that following passage through the holographic recording layer (8) it is totally internally reflected back into the holographic recording layer, and so that the object and reference beams (15,16) are superposed at the holographic recording layer (8);

**characterized in that the method includes**

   c) displacing said input laser beam so that the object and reference beams (15,16) traverse the holographic recording layer (8), and wherein directing the object and reference beams (15,16) to the holographic recording layer includes aligning the beams (15,16) and compressing or expanding the reference beam (16) or the object beam (15) in one dimension in order to compensate for the reference beam's projected cross section at the recording layer (8) and so that the beams (15,16) remain superposed as they traverse the holographic recording layer.

2. A method according to claim 1, wherein directing the object and reference beams (15,16) to the holographic recording layer (8) further includes arranging the optical path lengths of the object and reference beams (15,16) in order that the misalignment of the interfering beams at the holographic recording layer (8) produced by any angular displacement of the input beam is minimized.

3. A method according to claim 1, further including the step of changing the intensity of the input laser beam as it traverses the holographic recording layer (8).

4. A method according to claim 1, further including the steps of measuring and adjusting the separation between the object mask (11) and holographic layer (8) so that the separation of the object mask (11) and holographic recording layer (8) where the object and reference beams (15,16) are superposed remains constant as the object and reference beams traverse the holographic recording layer.

5. A method according to any of the preceding claims 1 to 4, wherein the input laser beam is displaced by a scanner system such that the beams travers the holographic recording layer (8) preferably in a raster scan.

6. An apparatus for recording a total internal reflection hologram, which apparatus includes:

a) a means (25) for dividing an input laser beam into an object beam (15) and a reference beam (16);

b) a means (26,27) for directing the object and reference beams (15,16) to a holographic recording layer surface so that the object beam (15) is incident on a surface of the holographic recording layer (8) following transmission through an object mask (11), so that the reference beam (16) is incident on the other surface of the holographic recording layer (8) at an angle such that following passage through the holographic recording layer (8) it is totally internally reflected back into the holographic recording layer, and so that the object and reference beams (15,16) are superposed at the holographic recording layer (8);

**characterized in that the apparatus includes**

c) a means (21) for displacing the input laser beam so that the object and reference beams (15,16) traverse the holographic recording layer (8), and wherein the means (26,27) for directing the object and reference beams (15,16) to the holographic recording layer (8), includes a prism (28), a diffraction grating or a cylindrical lens system for compressing or expanding the object beam (15) or the reference beam (16) in one dimension in order to compensate for the reference beam's projected cross section at the recording layer (8) and so that the beams (15,16) remain superposed as they traverse the holographic recording layer.

7. An apparatus according to claim 6, wherein the means for directing the object and reference beams to the holographic recording layer are arranged such that misalignment of the interfering object and reference beams (15,16) at the holographic recording layer (8) produced by any displacement of the input beam is minimized.

8. An apparatus according to claim 6 or 7, further including a means for measuring and adjusting the separation between the object mask (11) and recording layer (8) so that the separation of the object mask (11) and holographic recording layer (8) where the object and reference beams (15,16) are superposed remains constant as the object and reference beams (15,16) traverse the holographic recording layer (8).

**Patentansprüche**

1. Verfahren zur Aufzeichnung eines auf totaler innerer Reflexion beruhenden Hologramms, bei welchem Verfahren

a) ein eingehender Laserstrahl in einen Objektstrahl (15) und einen Referenzstrahl (16) aufgeteilt wird,

b) der Objektstrahl (15) und der Referenzstrahl (16) derart auf eine holografische Aufzeichnungsschicht (8) gerichtet werden, dass der Objektstrahl (15) nach dem Durchdringen einer Objektmaske auf einer Seite der Aufzeichnungsschicht (8) einfällt, und der Referenzstrahl (16) in einem solchen Winkel auf der anderen Seite der Aufzeichnungsschicht (8) einfällt, dass letzterer nach dem Durchgang durch die holografische Aufzeichnungsschicht (8) intern total zurück in die holografische Aufzeichnungsschicht (8) reflektiert wird, und dass der Objekt- und der Referenzstrahl (15,16) in der holografischen Aufzeichnungsschicht (8) überlagert werden

dadurch gekennzeichnet, dass bei dem Verfahren

c) der eingehende Laserstrahl derart verschoben wird, dass der Objektstrahl (15) und der Referenzstrahl (16) die holografische Aufzeichnungsschicht (8) überqueren, wobei das Ausrichten von Objekt- und Referenzstrahl (16) auf die holografische Aufzeichnungsschicht (8) eine Ausrichtung der Strahlen zueinander und ein Komprimieren oder Expandieren des Referenzstrahles oder des Objektstrahles in einer Dimension umfasst, um den auf die Aufzeichnungsschicht (8) projektierten Querschnitt des Referenzstrahls zu kompensieren, und dass die Strahlen während dem Überqueren der holografischen Schicht überlagert bleiben.

2. Verfahren nach Anspruch 1, bei welchem bei dem Richten von Objekt- und Referenzstrahl (16) auf die holografische Aufzeichnungsschicht (8) weiter die optischen Weglängen des Objektstrahls und des Referenzstrahls so eingerichtet werden, dass die durch eine Winkelverschiebung des eingehenden Strahles verursachte Ausrichtungsungenauigkeit der überlagerten Strahlen auf der holografischen Aufzeichnungsschicht (8) minimiert ist.

3. Verfahren nach Anspruch 1, bei welchem die Intensität des eingehenden Strahles während dem Überqueren der Aufzeichnungsschicht (8) verändert wird.

4. Verfahren nach Anspruch 1, bei welchem weiter der Abstand zwischen Objektmaske (11) und Aufzeichnungsschicht (8) gemessen und angepasst wird, so dass der Abstand der Objektmaske (11) und der holografischen Aufzeichnungsschicht (8) an der Stelle der Überlagerung von Objekt- und Referenzstrahl (15,16) konstant bleibt, wenn der Objekt- und der die Aufzeichnungsschicht (8) überquert.

5. Verfahren nach einem der vorangehenden Ansprüche 1 bis 4, bei welchem der eingehende Laserstrahl mit einem Scanner-System verschoben wird, so dass die Strahlen die holografische Aufzeichnungsschicht (8) vorzugsweise in einem Abtast-Raster (raster scan) überqueren.

6. Vorrichtung zur Aufzeichnung eines auf totaler innerer Reflexion beruhenden Hologramms, gekennzeichnet durch

a) eine Einrichtung zum Aufteilen eines eingehenden Laserstrahls in einen Objektstrahl (15) und einen Referenzstrahl (16),
b) eine Einrichtung zum Ausrichten von Objektstrahl (15) und Referenzstrahl (16) auf eine holografische Aufzeichnungsschicht derart, dass der Objektstrahl (15) nach dem Durchgang durch eine Objektmaske auf einer Seite der Aufzeichnungsschicht (8) einfällt, und der Referenzstrahl (16) in einem solchen Winkel auf der anderen Seite der Aufzeichnungsschicht (8) einfällt, dass er nach dem Durchdringen der holografischen Aufzeichnungsschicht (8) intern total zurück in die holografische Aufzeichnungsschicht (8) reflektiert wird, und der Objekt- und der Referenzstrahl (16) in der holografischen Aufzeichnungsschicht (8) überlagert werden

gekennzeichnet durch

c) eine Einrichtung zum Verschieben des eingehenden Laserstrahls, dass der Objektstrahl (15) und der Referenzstrahl (16) die holografische Aufzeichnungsschicht (8) überqueren, wobei die Einrichtung zum Ausrichten von Objekt- und Referenzstrahl (15,16) auf die holografische Aufzeichnungsschicht (8) ein Prismen-, ein Beugungsgitter- oder ein zylindrisches Linsensystem aufweist, um den Referenzstrahl (16) oder den Objektstrahl (15) in einer Dimension zu komprimieren oder zu expandieren, und so den auf die Aufzeichnungsschicht (8) projizierten Querschnitt des Referenzstrahls (16) zu kompensieren, und dass die Strahlen während dem Überqueren der holografischen Schicht überlagert bleiben.

7. Vorrichtung nach Anspruch 6, bei welcher die Einrichtung zum Ausrichten von Objekt- und Referenzstrahl (16) auf die holografische Aufzeichnungsschicht (8) derart angeordnet ist, dass die durch eine Verschiebung des eingehenden Strahles verursachte Ausrichtungsungenauigkeit der überlagerten Strahlen auf der holografischen Aufzeichnungsschicht (8) minimiert ist.

8. Vorrichtung nach Anspruch 6 oder 7, welche weiter eine Einrichtung zur Messung und Justierung des Abstandes zwischen der Objektrnaske und der Aufzeichnungsschicht (8)aufweist, so dass der Abstand zwischen Objektmaske und Aufzeichnungsschicht (8) an der Stelle der Überlagerung von Objekt- und Aufzeichnungsstrahl konstant bleibt, wenn der Objekt- und Referenzstrahl (15 resp. 16) die holografische Schicht (8) überqueren.

**Revendications**

1. Procédé d'enregistrement d'un hologramme à réflexion totale interne, qui comprend les étapes suivantes :

(a) division du faisceau laser d'entrée en un faisceau objet et un faisceau référence (16)
(b) direction des faisceaux objet et référence (15,16) vers une couche d'enregistrement holographique (8) de manière à ce que le faisceau objet soit incident sur une face de la couche d'enregistrement holographique (8) après transmission à travers un masque objet (11), que le faisceau de référence (16) soit incident sur l'autre face de la couche d'enregistrement holographique (8) selon un angle tel qu'après le passage à travers la couche d'enregistrement holographique (8) il soit totalement réfléchi vers l'intérieur de la couche d'enregistrement holographique, et que les faisceaux objet et référence (15, 16) soient superposés sur la couche d'enregistrement holographique (8) ;

caracterisé par le fait que le procédé comprend :

(c) le déplacement du dit faisceau d'entrée de manière à ce que les faisceaux objet et référence (15, 16) traversent la couche d'enregistrement holographique (8), et pour lequel l'orientation des faisceaux objet et référence (15, 16) vers la couche d'enregistrement holographique comprend l'alignement des faisceaux (15, 16) (...) et la compression ou l'expansion du faisceau référence (16) ou du faisceau objet (15) selon une dimension pour compenser la section transversale du faisceau référence projetée sur la couche d'enregistrement (8) et de telle sorte que les faisceaux (15, 16) restent superposés pendant qu'ils traversent la couche d'enregistrement holographique.

**2.** Procédé selon la revendication 1, selon laquelle la direction des faisceaux objet et référence (15, 16) vers la couche d'enregistrement holographique (8) comprend aussi l'arrangement de la longueur des chemins optiques des faisceaux objet et référence (15, 16) afin que le désalignement des faisceaux interférants dans la couche d'enregistrement holographique (8) provoqué par un déplacement angulaire du faisceau d'entrée soit minimisé.

**3.** Procédé selon la revendication 1, qui comprend l'étape supplémentaire du changement d'intensité du faisceau laser d'entrée pendant qu'il traverse la couche d'enregistrement holographique (8).

**4.** Procédé selon la revendication 1, qui comprend aussi les étapes de mesure et d'ajustement de la séparation entre le masque objet (11) et la couche holographique (8) pour que la séparation du masque objet (11) et de la couche d'enregistrement holographique (8) dans laquelle les faisceaux objet et référence (15, 16) sont superposés reste constante pendant que les faisceaux objet et référence traversent la couche d'enregistrement holographique.

**5.** Procédé selon toute les revendications précédentes 1 à 4, dans lequel le faisceau laser d'entrée est déplacé au moyen d'un système de balayage tel que les faisceaux traversent la couche d'enregistrement holographique (8) de préférence selon un schéma de balayage de trame.

**6.** Appareil d'enregistrement d'un hologramme à réflexion totale interne, lequel appareil comprend :

(a) un moyen (25) pour diviser un faisceau laser d'entrée en un faisceau objet (15) et un faisceau référence (16) ;
(b) un moyen (26, 27) pour diriger les faisceaux objet et référence (15, 16) vers la surface d'une couche d'enregistrement holographique pour que le faisceau objet (15) soit incident sur une face de la couche d'enregistrement holographique (8) après transmission à travers un masque objet (11), pour que le faisceau référence (16) soit incident sur l'autre face de la couche d'enregistrement holographique (8) selon un angle tel que suivant le passage à travers la couche d'enregistrement holographique (8) il soit totalement réfléchi à l'intérieur de la couche d'enregistrement holographique, et pour que les faisceaux objet et référence (15, 16) soient superposés sur la couche d'enregistrement holographique (8) ;

caracterisé par le fait que l'appareil comprend :

(c) un moyen (21) de déplacement du faisceau laser d'entrée pour que les faisceaux objet et référence (15, 16) traversent la couche d'enregistrement holographique (8), et où les moyens (26, 27) servant à diriger les faisceaux objet et référence (15, 16) vers la couche d'enregistrement holographique (8) comprennent un prisme (28), un réseau de diffraction ou un système de lentilles cylindriques pour la compression ou l'expansion du faisceau objet (15) ou du faisceau référence (16) selon une dimension de manière à compenser la section transversale du faisceau référence projetée sur la couche d'enregistrement (8) et de telle sorte que les faisceaux (15, 16) restent superposés pendant qu'ils traversent la couche d'enregistrement holographique.

**7.** Appareil selon la revendication 6, dans lequel le moyen pour diriger les faisceaux objet et référence vers la couche d'enregistrement holographique est arrangé de telle sorte que le désalignement des faisceaux objet et référence interférant (15, 16) dans la couche d'enregistrement holographique (8) provoqué par tout déplacement du faisceau d'entrée soit minimisé.

**8.** Appareil selon la revendication 6 ou 7, comprenant par ailleurs un moyen de mesure et d'ajustement la séparation entre le masque objet (11) et la couche d'enregistrement (8) pour que la séparation du masque objet (11) et la couche d'enregistrement holographique (8), dans laquelle les faisceaux objet et référence (15, 16) sont superposés, reste constante pendant que les faisceaux objet et référence (15, 16) traversent la couche d'enregistrement holographique (8).

EP 0 593 124 B1

Fig. 1

Fig. 2

Fig. 3

EP 0 593 124 B1